# FASCICULE DE BREVET EUROPEEN

(11) **EP 2 849 301 B1**
(45) Date de publication et mention de la délivrance du brevet: **14.11.2018**
(21) Numéro de dépôt: 14184630.3
(22) Date de dépôt: 12.09.2014
(51) Int. Cl.: H02H 11/00

(54) **Dispositif et procédé de sécurité pour installation électrique**
Sicherheitsvorrichtung und -verfahren für Elektrische Installationseinrichtung
Security method and device for a electrical installation arrangement

(30) Priorité: 16.09.2013 FR 1358888
(43) Date de publication de la demande: 18.03.2015
(73) Titulaire: Schneider Electric Industries SAS, 92500 Rueil-Malmaison (FR)
(72) Inventeur: Laporte, Alexandre, 38050 Grenoble Cedex 09 (FR); Vincent, François, 38050 Grenoble Cedex 09 (FR); Pellegrin, Christian, 38050 Grenoble Cedex 09 (FR)
(74) Mandataire: Lavoix

(56) Documents cités:
- CA-A1- 2 586 812
- US-A1- 2003 184 931

## Description

La présente invention concerne un dispositif de sécurité pour installation électrique selon la revendication 1.

La présente invention concerne également un procédé de vérification de sécurité associé.

L'invention se situe dans le domaine de la distribution d'énergie électrique à des installations électriques industrielles consommatrices de forte puissance.

De manière connue, les installations électriques industrielles de forte puissance sont alimentées par un fournisseur d'énergie électrique, via un réseau de distribution d'énergie électrique.

Afin de protéger les diverses installations électriques d'un système électrique, il est connu de placer des dispositifs de sécurité, tels de disjoncteurs, sur les lignes d'alimentation des diverses installations électriques, permettant de couper une alimentation en énergie électrique en cas de surintensité ou d'incident, de manière à éviter d'endommager les installations électriques d'un tel système.

En cas de survenue d'incident, par exemple de surintensité, un opérateur de maintenance intervient pour réparer ou remplacer un équipement défectueux qui est la source de l'incident, pour ensuite remettre en fonctionnement le système électrique. L'opération de remise en fonctionnement s'accompagne de la « fermeture » du ou des disjoncteurs, ce qui permet la réalimentation des installations en énergie électrique. Il existe un risque de sécurité pour un opérateur de maintenance effectuant cette opération de remise en fonctionnement, notamment dans le cas des installations de puissance, car il existe un risque d'existence d'un court-circuit en aval du disjoncteur, ce qui peut provoquer des effets risquant de blesser l'opérateur.

Divers systèmes ont été proposés pour détecter une éventuelle présence de court-circuit afin d'augmenter la sécurité pour des opérateurs de maintenance.

Outre la présence d'un court-circuit, il est également possible que le système électrique à remettre en fonction comporte une tension résiduelle provenant d'une source située en aval du disjoncteur, ce qui met également un opérateur de maintenance en danger et risque d'endommager divers composants de l'installation.

Par exemple, lorsqu'un système de distribution d'électricité comportant plusieurs installations électriques est alimenté par un courant électrique triphasé, à 690V et ayant une fréquence de 50Hz, une tension résiduelle supérieure à 50V et inférieure ou égale à 690V peut être présente.

Le document US6034447 décrit un circuit permettant de tester la présence de court-circuit, mais ne s'applique pas dans le cas d'une fourniture de courant électrique par un réseau de distribution triphasé, comportant trois conducteurs de phase, un conducteur neutre et un conducteur de protection, mais seulement dans le cas d'un réseau de distribution monophasé. De plus, le circuit proposé dans ce document nécessite un interrupteur coûteux, dans la mesure où il doit pouvoir supporter toutes les surtensions possibles.

Le document US 2003/0184931 A1 (les caractéristiques connues figurant dans le préambule) décrit un dispositif interrupteur de circuit électrique, comportant un disjoncteur et un module de protection, adapté à être utilisé dans un réseau de distribution triphasé.

Il existe un besoin d'améliorer les systèmes de sécurité avant remise en fonction d'un système de distribution électrique, postérieurement à une disjonction, en termes de coûts, d'efficacité et de sécurité.

A cet effet, l'invention propose, selon un premier aspect, un dispositif de sécurité du type mentionné ci-dessus, selon la revendication 1.

Avantageusement, le dispositif de l'invention comporte des moyens de vérification de présence d'une tension résiduelle et des moyens de vérification d'isolement entre conducteurs de phase, donc plusieurs conditions de sécurité sont cumulées.

Selon une caractéristique particulière, les moyens de vérification d'isolement du dispositif selon l'invention sont aptes à vérifier chaque paire de conducteurs de phase, ainsi que chaque conducteur de phase et le conducteur neutre ou le conducteur de protection.

Ainsi, avantageusement, toutes les paires de conducteurs parmi l'ensemble des conducteurs de courant triphasé sont testées, de manière exhaustive, permettant d'augmenter la sécurité.

Le dispositif de sécurité selon l'invention peut également présenter une ou plusieurs des caractéristiques ci-dessous :
- les moyens de vérification d'isolement comportent en outre, branché en sortie du circuit de multiplexage, et raccordé auxdits conducteurs de phase, un filtre d'injection de type passe-haut, ayant une fréquence de coupure supérieure à ladite première fréquence du courant triphasé et inférieure à ladite deuxième fréquence du signal électrique haute fréquence ;
- le circuit de multiplexage du signal électrique haute fréquence injecté comporte un ensemble d'organes de commutation agencés pour réaliser un couplage entre lesdits conducteurs de la ligne d'acheminement du réseau électrique triphasé et le signal électrique haute fréquence injecté ;
- le circuit de multiplexage comporte cinq organes de commutation ayant chacun une entrée commutable sur une sortie parmi deux sorties, branchés de manière à ce que chacun des conducteurs électriques de la ligne d'acheminement du réseau soit branché sur au moins une sortie d'un organe de commutation ;
- chaque conducteur de phase est branché en sortie de deux organes de commutation distincts ;
- il comporte un module d'adaptation de mesure et un circuit de mesure de tension branché en sortie du module d'adaptation de mesure et apte à réaliser une mesure de tension indiquant la présence d'une tension résiduelle et une mesure d'impédance indiquant l'absence de défaut d'isolement électrique pour chaque paire de conducteurs testée ;
- il comporte un organe de contrôle commande apte à contrôler lesdits moyens de vérification de présence d'une tension résiduelle et lesdits moyens de vérification d'isolement ;
- il comporte une interface homme-machine apte à recevoir des commandes d'un opérateur et à fournir des indications relatives aux conditions de sécurité vérifiées ;
- l'interface homme-machine comporte des indicateurs lumineux aptes à fournir des indications relatives aux conditions de sécurité vérifiées.

Selon un deuxième aspect, l'invention concerne un procédé de vérification de sécurité mis en oeuvre par un dispositif de sécurité selon la revendication 1. Le procédé de vérification selon l'invention comporte :
- la vérification d'une première condition de sécurité de présence d'une tension supérieure à un seuil de sécurité prédéterminé sur un des conducteurs de phase,
- et, en cas d'absence de tension supérieure au seuil de sécurité, la vérification d'isolement, apte à vérifier l'isolement entre deux conducteurs d'au moins une paire de conducteurs, dite paire de conducteurs testée, parmi lesdits conducteurs de phase,
- l'affichage au moyen d'une interface homme machine du dispositif de sécurité du résultat à chaque étape de vérification.

Les avantages du procédé de vérification selon l'invention sont analogues à ceux du dispositif de sécurité brièvement décrit ci-dessus.

Selon un mode de réalisation, le procédé de vérification de sécurité comporte en outre, après la vérification de la première condition de sécurité, la vérification d'une deuxième condition de sécurité de perte liaison avec un des conducteurs de phase.

Selon un mode de réalisation, à l'étape de vérification d'isolement, toutes les paires de conducteurs de phase, toutes les paires formées respectivement par un des conducteurs de phase et le conducteur neutre et toutes les paires formées respectivement par un des conducteurs de phase et le conducteur de protection sont vérifiées.

De préférence, un indicateur de risque est mis en oeuvre sur l'interface homme-machine du dispositif de sécurité dès que l'étape de vérification d'isolement indique une absence d'isolement pour une paire de conducteurs.

De préférence, lesdites première et deuxième conditions de sécurité sont vérifiées avant et après la mise en oeuvre de l'étape de vérification d'isolement.

D'autres caractéristiques et avantages de l'invention ressortiront de la description qui en est donnée ci-dessous, à titre indicatif et nullement limitatif, en référence aux figures annexées, parmi lesquelles :
- la figure 1 représente schématiquement un système de distribution électrique mettant en oeuvre des dispositifs de sécurité selon l'invention ;
- la figure 2 représente schématiquement un ensemble de blocs fonctionnels d'un dispositif de sécurité selon l'invention ;
- la figure 3 représente schématiquement un mode de réalisation d'un dispositif de sécurité selon l'invention ;
- la figure 4 représente schématiquement un mode de réalisation d'un circuit de multiplexage ;
- la figure 5 illustre des combinaisons de signal électrique d'injection ;
- la figure 6 représente schématiquement un mode de réalisation d'un circuit de mesure.

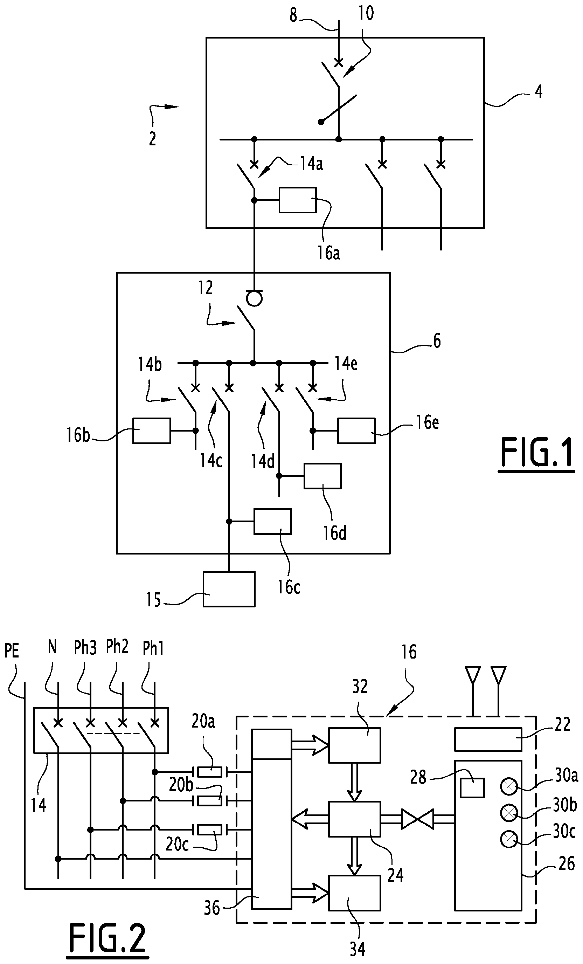

La figure 1 illustre schématiquement un exemple de système 2 de distribution d'énergie électrique dans lequel l'invention trouve une application. Ainsi, le principe général de l'invention sera décrit ci-après, en particulier en référence à cette figure.

Le système 2 de distribution d'énergie électrique comporte deux tableaux électriques de distribution, notés respectivement 4 et 6 sur la figure, qui peuvent être situés physiquement dans des bâtiments différents, par exemple d'un site industriel. Ce système 2 permet l'alimentation de diverses installations électriques de puissance 15, également appelées charges, raccordées dans cet exemple au tableau électrique 6.

Le tableau électrique 4, dit tableau principal, est directement alimenté, via une ligne d'acheminement de courant électrique 8, avec un courant électrique triphasé fourni par un distributeur d'énergie électrique, par exemple EDF (« Electricité de France »). La ligne d'acheminement de courant électrique 8 comporte trois conducteurs de phase notés PH1, PH2, PH3 et visibles sur la figure 2, optionnellement un conducteur neutre N et un conducteur de protection PE relié à la terre.

Chaque tableau électrique 4, 6 comporte un interrupteur principal, respectivement référencés 10 pour le tableau électrique 4 et 12 pour le tableau électrique 6, permettant de couper l'arrivée de courant électrique sur la ligne d'alimentation 8. En outre, des dispositifs disjoncteurs 14a, 14b, 14c, 14d et 14e sont placés sur les diverses lignes d'alimentation du système de distribution 2, de manière à protéger les divers composants du système de distribution en cas d'incident, en particulier en cas de surintensité due à une charge défectueuse connectée au système de distribution.

Ainsi, lorsqu'un incident se produit, le dispositif disjoncteur coupe l'alimentation en courant, et se place donc en position d'ouverture. Un opérateur de maintenance peut alors intervenir pour éliminer la source de l'incident, et ensuite remettre le système de distribution 2 en fonctionnement par fermeture du dispositif disjoncteur concerné.

Afin d'assurer une meilleure sécurité d'un opérateur de maintenance, des dispositifs de sécurité 16a, 16b, 16c, 16d et 16e sont ajoutés dans le système de distribution d'énergie, chaque dispositif de sécurité 16a à 16e étant branché en aval d'un dispositif disjoncteur 14a à 14e associé.

Chaque dispositif de sécurité selon l'invention est apte à vérifier plusieurs conditions de sécurité, à savoir, une première condition de sécurité qui est la présence d'une tension électrique en aval du dispositif disjoncteur associé, optionnellement une deuxième condition de sécurité qui consiste à vérifier la perte éventuelle d'une liaison du dispositif de sécurité à un conducteur de phase, et enfin une troisième condition de sécurité concernant la présence éventuelle d'un court-circuit entre conducteurs de phase et/ou entre chaque conducteur de phase et les conducteurs neutre et de protection.

La figure 2 illustre schématiquement un ensemble de blocs fonctionnels d'un dispositif de sécurité 16 selon l'invention.

Un dispositif de sécurité 16 est raccordé à chacun des conducteurs de phase PH1, PH2, PH3 de la ligne d'alimentation, en aval d'un dispositif disjoncteur 14 associé, par l'intermédiaire d'organes de protection de type fusibles 20a, 20b, 20c. Ces organes de protection 20a, 20b, 20c permettent d'isoler le dispositif de sécurité 16 des conducteurs de phase pour toute intervention sur le dispositif de sécurité, et également d'éviter de provoquer un court-circuit entre les conducteurs de phase PH1, PH2, PH3 en cas de défaillance du dispositif de sécurité 16.

Le dispositif de sécurité 16 est alimenté par une source extérieure de courant continu de tension 24V, par exemple via un bloc d'alimentation 22.

Le dispositif de sécurité 16 comporte un bloc fonctionnel de contrôle commande 24, connecté à un bloc d'interface homme machine 26, permettant d'obtenir des commandes utilisateur, via par exemple des boutons de commande 28, et d'afficher des résultats des tests de sécurité mis en oeuvre par le dispositif de sécurité, par exemple par des indicateurs lumineux 30a, 30b, 30c.

Le bloc de contrôle commande 24 pilote un bloc 32 de vérification de présence tension, apte à vérifier la présence d'une tension résiduelle, de préférence inférieure à 50V, par exemple égale à 30V, de fréquence donnée égale par exemple à 50Hz. Tel est le cas si une source d'alimentation est connectée en aval du dispositif disjoncteur associé 14, malgré le fait que ce dispositif disjoncteur 14 soit lui-même en position de coupure de l'alimentation amont.

En outre, le dispositif de sécurité 16 comporte un bloc de mesure 34, connecté à un bloc de multiplexage 36, aptes à générer un signal électrique d'injection haute fréquence, basse tension, par exemple de tension inférieure à 50V, de fréquence 50KHZ, entre les divers conducteurs de phase PH1, PH2, PH3, conducteur neutre N, conducteur de protection PE selon diverses combinaisons possibles, et de mesurer une impédance de court-circuit, permettant de détecter une éventuelle présence de court-circuit entre les conducteurs.

Dans un mode de réalisation tel qu'illustré à la figure 2, les fonctions de vérification 32 de présence tension et de mesure 34 d'impédance de court-circuit sont réalisées, avantageusement, par un même circuit de vérification et de mesure qui sera décrit plus en détail ci-après.

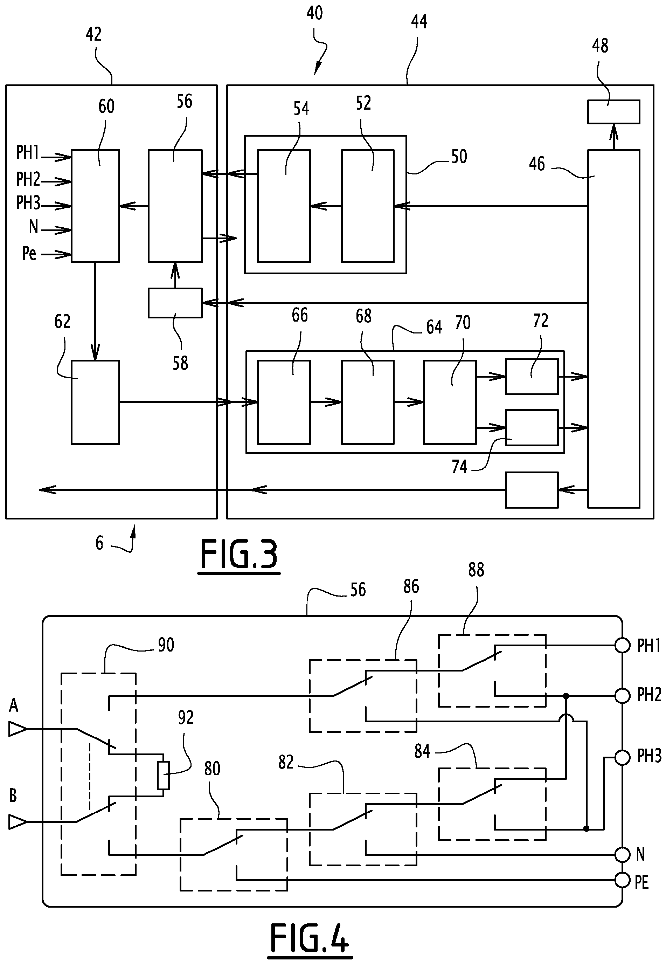

Selon un mode de réalisation illustré à la figure 3, un dispositif de sécurité 40 est composé de deux blocs électroniques 42, 44, reliés par un bloc de connectique non représenté, le bloc 42, connecté à la ligne d'acheminement de courant triphasé, étant apte à supporter un signal électrique de puissance, ayant une tension de 690V, et le bloc 44 étant apte à effectuer des opérations de mesure basse tension destinées à la vérification des conditions de sécurité avant remise en service du dispositif disjoncteur associé au dispositif de sécurité.

Le bloc électronique 42 est alimenté par une alimentation extérieure 24V à courant continu par exemple, comme expliqué ci-dessus.

Le bloc 44 comporte des moyens de calcul, comme par exemple un microprocesseur 46 apte à effectuer des fonctions de commande et de contrôle, en lien avec une interface homme-machine 48 permettant une interaction avec un opérateur.

Le microprocesseur 46 est apte à commander un module 50 d'injection d'un signal électrique haute fréquence, basse tension, qui est mis en forme par un module 52 et amplifié par un module d'amplification de puissance 54, avant d'être injecté vers un circuit de multiplexage 56. Le circuit de multiplexage 56 est commandé par un module de commande 58, apte à commander des organes de commutation permettant de sélectionner une paire de conducteurs à tester parmi l'ensemble des conducteurs de courant triphasé. Un mode de réalisation du circuit de multiplexage 56 sera détaillé ci-après en référence à la figure 4.

La sortie du circuit de multiplexage 56 est branchée en entrée d'un filtre d'injection passe-haut 60, qui est également raccordé aux conducteurs de phase PH1, PH2, PH3, au conducteur neutre N et au conducteur de protection PE.

Le filtre d'injection passe-haut 60 est un filtre de type RC, ayant une fréquence de coupure choisie pour laisser passer un signal haute fréquence injecté et pour atténuer, voire couper, un signal électrique basse fréquence, haute tension, en provenance des conducteurs de phase. Par exemple, dans un mode de réalisation, le filtre d'injection 60 passe-haut est composé de résistances de 1 Kilo-Ohms et capacités de 33nF (nano Farads), ce qui permet d'obtenir une fréquence de coupure de 4,822 KHz.

La sortie du filtre d'injection 60 est branchée en entrée d'un module d'adaptation de mesure 62, qui a pour fonction de permettre d'adapter le signal électrique injecté pour la vérification de l'isolement entre conducteurs et la vérification d'une éventuelle présence de court-circuit d'une part, et d'adapter un signal électrique du réseau pour la vérification de présence de tension résiduelle.

Le module d'adaptation de mesure 62 est avantageusement réalisé pour résister aux perturbations éventuelles présentes sur le réseau électrique, de type onde de foudre.

Dans un mode de réalisation, le module d'adaptation mesure 62 est réalisé par un circuit qui réalise un filtrage apte à couper un signal électrique de fréquence inférieure à 10 KHz. Ce filtre est destiné à laisser passer la fréquence d'injection et à atténuer la fréquence réseau.

Le module d'adaptation mesure 62 est connecté à un circuit de mesure 64, faisant partie du bloc électronique 44. Le circuit de mesure 64 est composé d'un module de protection et de filtrage 66, d'un module de multiplexage de mesures 68, d'un module d'amplification et de redressement 70. Le module d'amplification et de redressement 70 a deux sorties, une sortie vers un module de filtrage 72, qui est un filtre intégrateur à valeur moyenne 50KHz, et une sortie vers un module de filtrage 74, comprenant un pont diviseur de tension et un filtre intégrateur de valeur moyenne 50Hz.

Le module de filtrage 72 permet de fournir une valeur de mesure de tension entre deux conducteurs d'une paire de phases testée ou entre un des conducteurs de phase et le conducteur neutre ou le conducteur de protection, permettant d'obtenir une valeur de résistance (ou impédance) qui est comparée ensuite à un seuil d'isolement prédéterminé pour déterminer si la condition d'isolement entre la paire de conducteurs est satisfaite, ou si, au contraire, un court-circuit est présent entre les deux conducteurs de la paire de conducteurs testée. La condition d'isolement est de préférence donnée par un seuil de résistance d'isolement, de l'ordre de quelques ohms à quelques dizaines d'ohms. Si la valeur obtenue par mesure est inférieure au seuil de résistance d'isolement, un court-circuit est détecté.

Si la condition d'isolement indique qu'un court-circuit est présent entre les deux conducteurs de la paire de conducteurs testée, un risque de défaut de sécurité est signalé à l'opérateur via l'interface homme-machine 48 du dispositif de sécurité 40.

Le module de filtrage 74 fournit une valeur de mesure de présence tension à 50Hz, entre deux conducteurs d'une paire de phases testée ou entre un des conducteurs de phase PH1, PH2, PH3 et le conducteur de protection ou le conducteur neutre, pour une plage de tensions supérieure à 50 Volts. En cas de détection de présence d'une tension, un signalement adéquat est transmis à l'opérateur via l'interface homme-machine 48 du dispositif de sécurité. De plus, toute injection de signal de vérification d'isolement est inhibée en cas de détection de présence d'une tension.

La figure 4 illustre un mode de réalisation d'un circuit de multiplexage 56 de signaux électriques d'injection. Dans ce mode de réalisation, le circuit de multiplexage est constitué d'une pluralité d'organes de commutation 80, 82, 84, 86, 88, qui sont de préférence des relais électromécaniques, à une entrée et deux sorties, permettant une commutation d'un conducteur d'entrée vers une des deux sorties possibles. Les organes de commutation sont branchés de manière à permettre un couplage entre les conducteurs de phase PH1, PH2, PH3, le conducteur neutre, le conducteur de protection PE et le signal électrique d'injection fourni sur l'entrée A, B. En outre, le circuit de multiplexage 56 comporte un organe de commutation inverseur 90, branché à une résistance de test 92, permettant de déconnecter le module d'injection 60 du réseau électrique.

Le câblage des organes de commutation 80 à 90 permet de réaliser toutes les combinaisons de mesure pour vérifier l'isolement et vérifier un éventuel court-circuit entre les paires de conducteurs, c'est-à-dire entre paires de conducteurs de phase : (PH1, PH2), (PH1, PH3), (PH2, PH3) ; entre chaque conducteur de phase et le conducteur neutre: (PH1, N), (PH2, N), (PH3, N) ; entre chaque conducteur de phase et le conducteur de protection (PH1, PE), (PH2, PE), (PH3, PE).

Avantageusement, le câblage choisi permet d'utiliser le nombre minimal d'organes de commutation 80 à 90 pour réaliser l'ensemble de combinaisons à tester, permettant ainsi de minimiser l'encombrement total et le coût du dispositif de sécurité.

Le circuit de multiplexage 56 comporte cinq organes de commutation 80, 82, 84, 86, 88 ayant une entrée commutable sur une sortie parmi deux sorties, branchés de manière à ce que chacun des conducteurs électriques PH1, PH2, PH3, N, PE de la ligne d'acheminement du réseau soit branché sur au moins une sortie d'un organe de commutation 80, 82, 84, 86, 88.

De plus, dans le mode de réalisation de la figure 4, chaque conducteur de phase PH1, PH2, PH3 est branché en sortie de deux organes de commutation distincts parmi les cinq organes de commutation 80, 82, 84, 86, 88.

De préférence, la résistance de contact entre les organes de commutation est la plus faible possible pour éviter une chute de tension. De préférence, la résistance de contact de chaque organe de commutation est inférieure à 50 milli-Ohms, ce qui permet d'avoir une résistance totale, dans le pire cas, de 7x50mOhm=350milli-Ohms.

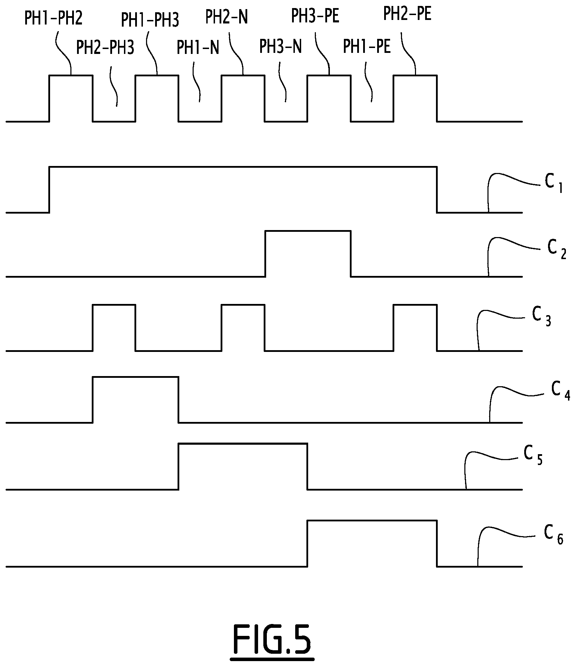

Avec le câblage illustré à la figure 4, le module de commande 58 applique les commandes suivantes pour obtenir un multiplexage du signal d'injection sur chacune des paires de conducteurs à tester, comme illustré à la figure 5. Pour chaque organe de commutation, un signal de commande associé est représenté à la figure 5. Le signal de commande C1 est associé à l'organe de commutation 90, C2 à l'organe de commutation 86, C3 à l'organe de commutation 88, C4 à l'organe de commutation 84, C5 à l'organe de commutation 82 et C6 à l'organe de commutation 80.
- paire (PH1, PH2) : commande de l'organe de commutation : 90
- paire (PH2, PH3) : commande des organes de commutation 90, 84, 88 ;
- paire (PH1, PH3) : commande des organes de commutation 90, 84 ;
- paire (PH1, N) : commande des organes de commutation 90, 82 ;
- paire (PH2, N) : commande des organes de commutation 90, 82, 88 ;
- paire (PH3, N) : commande des organes de commutation 90, 82, 86 ;
- paire (PH1, PE) : commande des organes de commutation 90, 80 ;
- paire (PH2, PE) : commande des organes de commutation 90, 80, 88 ;
- paire (PH3, PE) : commande des organes de commutation 90, 80, 86 ;

Ainsi, avantageusement, toutes les combinaisons sont testées, avec un nombre minimal d'organes de commutation.

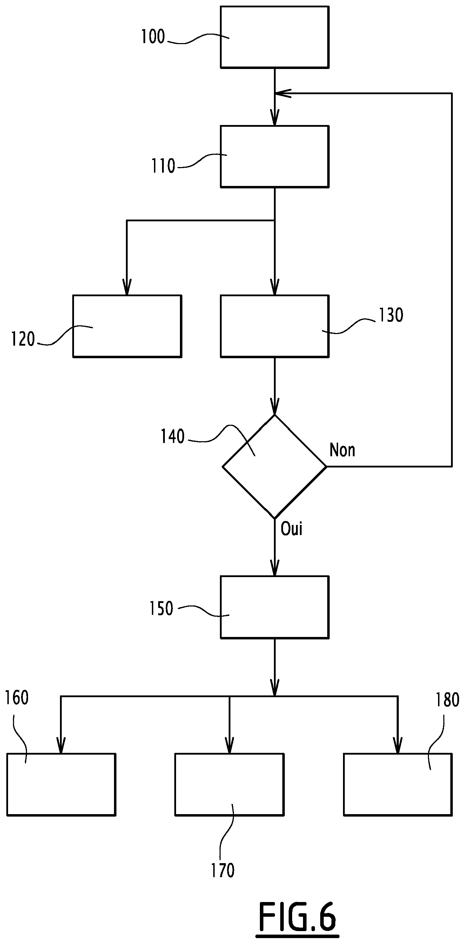

La figure 6 illustre les principales étapes d'un procédé de vérification de conditions de sécurité mis en oeuvre par un dispositif de sécurité tel que décrit ci-dessus.

De préférence, le dispositif de sécurité mesure en permanence une première condition de sécurité, qui est la présence de tension sur les conducteurs de phase PH1, PH2, PH3. La vérification de présence de court-circuit entre conducteurs n'est effectuée que lorsqu'il est garanti qu'aucune tension supérieure à un seuil de sécurité, qui est de préférence inférieur à 50V, par exemple égal à 30V pour une très basse tension de sécurité, n'est présente sur les conducteurs de phase.

En outre, le dispositif de sécurité vérifie une deuxième condition de sécurité, qui est la perte d'une liaison avec un conducteur de phase, due à un fusible 20a, 20b, 20c défectueux ou à un problème de connectique. La vérification d'isolement entre conducteurs pour valider une absence de court-circuit, qui est une troisième condition de sécurité, n'est effectuée qu'après la vérification de ces deux conditions de sécurité.

De préférence, les première et deuxième conditions de sécurité sont validées à nouveau après la vérification de la troisième condition de sécurité.

Les principales étapes d'un procédé selon l'invention sont illustrées à la figure 6. Une première étape 100 de mise sous tension d'alimentation (24V) du dispositif de sécurité est mise en oeuvre. Un voyant lumineux témoin de mise sous tension, visible sur une face du dispositif de sécurité, est alors allumé.

Elle est suivie d'une vérification 110 de la deuxième condition de sécurité, c'est-à-dire de la perte éventuelle d'une liaison avec un des conducteurs de phase.

En cas de perte de liaison, par exemple à cause d'un fusible hors service, un indicateur lumineux est allumé à l'étape 120, pour signaler cette anomalie à l'opérateur de maintenance. Par exemple, un indicateur 30c clignotant de couleur jaune signale cette anomalie.

Dans le cas où la vérification de perte de liaison est négative, l'étape 110 est suivie d'une étape 130 à laquelle un indicateur lumineux, par exemple le même indicateur 30c, est éteint.

A tout instant, un opérateur peut agir sur un bouton, par exemple le bouton 28, pour demander un test de sécurité. La vérification de l'arrivée d'une telle requête d'un opérateur est faite à l'étape 140. Tant qu'il n'y a pas de demande de vérification de sécurité demandée par un opérateur, le procédé retourne à l'étape 110 précédemment décrite.

Ainsi, avantageusement, l'état de la liaison avec les conducteurs de phase est surveillé constamment.

En cas de demande de vérification de sécurité à l'étape 140, une étape de vérification de sécurité 150 en lancée, comportant une première vérification de présence d'une tension supérieure au seuil de sécurité donné. Si une telle présence est détectée, l'indicateur lumineux 30c s'allume lors d'une étape 160 pour indiquer l'impossibilité de poursuivre la vérification d'isolement des conducteurs. Ainsi, aucun signal électrique haute fréquence n'est injecté pour le test d'isolement par paires de conducteurs.

Si aucune tension supérieure au seuil de sécurité n'est détectée pour aucun des conducteurs de phase, alors l'ensemble de paires de conducteurs est testé par injection d'un signal électrique haute fréquence comme expliqué ci-dessus lors de cette étape de vérification de sécurité 150.

En cas de détection de présence d'un court-circuit sur une des paires de conducteurs testée, un indicateur lumineux 30b indiquant cette présence de court-circuit est allumé à l'étape 170. Ainsi, l'opérateur est prévenu d'un risque de sécurité, et donc ne remet pas le système de distribution d'énergie électrique en fonctionnement par fermeture du dispositif disjoncteur en amont du dispositif de sécurité. Par exemple, l'indicateur lumineux 30b est allumé en rouge. Tout autre moyen d'indication d'un risque de sécurité via l'interface homme machine du dispositif de sécurité est utilisable en alternative.

Enfin, si aucune présence de court-circuit n'est détectée, alors un indicateur lumineux 30a indiquant que les vérifications de conditions de sécurité ont donné un résultat positif est allumé à l'étape 180. Par exemple, l'indicateur lumineux 30a est allumé en vert.

Il est à noter que toutes variantes de signalisation des tests des conditions de sécurité, à plusieurs indicateurs lumineux séparés par exemple, sont envisageables en alternative.

Avantageusement, plusieurs conditions de sécurité sont testées, et les résultats sont indiqués à l'opérateur sur l'interface homme machine du dispositif de sécurité, ce qui permet de gagner en fiabilité et en temps de maintenance. De plus, le cumul de test de plusieurs conditions de sécurité permet d'améliorer la sécurité d'un opérateur, ainsi que de diminuer les risques d'endommagement des composants.

## Revendications

1. Dispositif de sécurité (16, 16a, 16b, 16c, 16d, 16e, 40) apte à être branché entre un dispositif disjoncteur (14, 14a, 14b, 14c, 14d, 14e) et une installation électrique alimentée par un réseau électrique fournissant du courant triphasé ayant une première fréquence associée, au moyen d'une ligne (8) d'acheminement de courant électrique comportant trois conducteurs de phase (PH1, PH2, PH3), un conducteur neutre (N) et un conducteur de protection (PE), le dispositif permettant de vérifier au moins une condition de sécurité électrique suite à une coupure d'alimentation électrique de l'installation électrique par le dispositif disjoncteur (14, 14a, 14b, 14c, 14d, 14e), **caractérisé en ce qu'**il comporte des moyens de vérification (32) de présence d'une tension résiduelle supérieure à un seuil de sécurité prédéterminé sur au moins un des conducteurs et des moyens de vérification (34, 36) d'isolement, aptes à vérifier l'isolement entre deux conducteurs d'au moins une paire de conducteurs, dite paire de conducteurs testée, parmi lesdits conducteurs de phase, lesdits moyens de vérification d'isolement comportant un module (50) d'injection d'un signal électrique haute fréquence, ayant une tension inférieure à un seuil de tension, et une deuxième fréquence supérieure à ladite première fréquence, et un circuit de multiplexage (56) permettant d'injecter ledit signal électrique haute fréquence vers chaque paire de conducteurs à tester.

2. Dispositif de sécurité selon la revendication 1, **caractérisé en ce que** les moyens de vérification (34, 36) d'isolement sont aptes à vérifier chaque paire de conducteurs de phase.

3. Dispositif de sécurité selon l'une des revendications 1 ou 2, **caractérisé en ce que** les moyens de vérification (34, 36) d'isolement sont aptes en outre à vérifier l'isolement de chaque paire de conducteurs formée par chacun desdits conducteurs de phase et le conducteur neutre, et de chaque paire de conducteurs formée par chacun desdits conducteurs de phase et le conducteur de protection.

4. Dispositif de sécurité selon l'une quelconque des revendications 1 à 3, **caractérisé en ce que** les moyens de vérification (34, 36) d'isolement comportent en outre, branché en sortie du circuit de multiplexage (56), et raccordé auxdits conducteurs de phase, un filtre d'injection (60) de type passe-haut, ayant une fréquence de coupure supérieure à ladite première fréquence du courant triphasé et inférieure à ladite deuxième fréquence du signal électrique haute fréquence.

5. Dispositif de sécurité selon l'une quelconque des revendications 1 à 4 , **caractérisé en ce que** le circuit de multiplexage (56) du signal électrique haute fréquence injecté comporte un ensemble d'organes de commutation (80, 82, 84, 86, 88) agencés pour réaliser un couplage entre lesdits conducteurs de la ligne (8) d'acheminement du réseau électrique triphasé et le signal électrique haute fréquence injecté.

6. Dispositif de sécurité selon la revendication 5, **caractérisé en ce que** le circuit de multiplexage (56) comporte cinq organes de commutation (80, 82, 84, 86, 88) ayant chacun une entrée commutable sur une sortie parmi deux sorties, branchés de manière à ce que chacun des conducteurs électriques (PH1, PH2, PH3, N, PE) de la ligne (8) d'acheminement du réseau soit branché sur au moins une sortie d'un organe de commutation (80, 82, 84, 86, 88).

7. Dispositif de sécurité selon la revendication 6, **caractérisé en ce que** chaque conducteur de phase (PH1, PH2, PH3) est branché en sortie de deux organes de commutation (80, 82, 84, 86, 88) distincts.

8. Dispositif de sécurité selon l'une quelconque des revendications 4 à 7, **caractérisé en ce qu'**il comporte un module d'adaptation de mesure (62) et un circuit de mesure (64) de tension branché en sortie du module d'adaptation de mesure (62) et apte à réaliser une mesure de tension indiquant la présence d'une tension résiduelle et une mesure d'impédance indiquant l'absence de défaut d'isolement électrique pour chaque paire de conducteurs testée.

9. Dispositif de sécurité selon l'une quelconque des revendications précédentes, **caractérisé en ce qu'**il comporte un organe de contrôle commande (24, 46) apte à contrôler lesdits moyens de vérification (32) de présence d'une tension résiduelle et lesdits moyens de vérification (34, 36) d'isolement.

10. Dispositif de sécurité selon la revendication 9, **caractérisé en ce qu'**il comporte une interface homme-machine (26, 48) apte à recevoir des commandes d'un opérateur et à fournir des indications relatives aux conditions de sécurité vérifiées.

11. Dispositif de sécurité selon la revendication 10, **caractérisé en ce que** l'interface homme-machine comporte des indicateurs lumineux (30a, 30b, 30c) aptes à fournir des indications relatives aux conditions de sécurité vérifiées.

12. Procédé de vérification de sécurité mis en oeuvre par un dispositif de sécurité selon la revendication 1, **caractérisé en ce qu'**il comporte :
- la vérification (150) d'une première condition de sécurité de présence d'une tension supérieure à un seuil de sécurité prédéterminé sur un des conducteurs de phase,
- et, en cas d'absence de tension supérieure au seuil de sécurité, la vérification (150) d'isolement, apte à vérifier l'isolement entre deux conducteurs d'au moins une paire de conducteurs, dite paire de conducteurs testée, parmi lesdits conducteurs de phase,
- l'affichage (160, 170, 180) au moyen d'une interface homme machine du dispositif de sécurité du résultat à chaque étape de vérification.

13. Procédé de vérification de sécurité selon la revendication 12, **caractérisé en ce qu'**il comporte en outre, après la vérification de la première condition de sécurité, la vérification (110) d'une deuxième condition de sécurité de perte liaison avec un des conducteurs de phase.

14. Procédé de vérification de sécurité selon l'une quelconque des revendications 12 ou 13, **caractérisé en ce qu'**à l'étape de vérification (150) d'isolement, toutes les paires de conducteurs de phase, toutes les paires formées respectivement par un des conducteurs de phase et le conducteur neutre et toutes les paires formées respectivement par un des conducteurs de phase et le conducteur de protection sont vérifiées.

15. Procédé de vérification de sécurité selon la revendication 14, **caractérisé en ce qu'**un indicateur de risque est mis en oeuvre sur l'interface homme-machine du dispositif de sécurité dès que l'étape de vérification d'isolement indique une absence d'isolement pour une paire de conducteurs.

16. Procédé de vérification de sécurité selon la revendication 13 et l'une des revendications 14 à 15, **caractérisé en ce que** lesdites première et deuxième conditions de sécurité sont vérifiées avant et après la mise en oeuvre de l'étape de vérification d'isolement.

## Patentansprüche

1. Sicherheitsvorrichtung (16, 16a, 16b, 16c, 16d, 16e, 40), die ausgebildet ist, zwischen eine Trennvorrichtung (14, 14a, 14b, 14c, 14d, 14e) und eine elektrische Anlage geschaltet zu werden, die von einem elektrischen Netz versorgt wird, das von einem eine erste zugeordnete Frequenz aufweisenden Dreiphasenstrom mittels einer stromführenden elektrischen Leitung versorgt wird, die drei Phasenleiter (PH1, PH2, PH3), einen Nullleiter (N) und einen Schutzleiter (PE) aufweist, wobei die Vorrichtung ermöglicht, mindestens eine elektrische Sicherheitsbedingung folgend auf eine Trennung der elektrischen Versorgung der elektrischen Vorrichtung durch die Trennvorrichtung (14, 14a, 14b, 14c, 14d, 14e) zu überprüfen, **dadurch gekennzeichnet, dass** sie Mittel (32) zur Überprüfung des Vorhandenseins einer Restspannung auf einem der Leiter, die größer ist als eine vorbestimmte Sicherheitsschwelle, und Mittel (34, 36) zur Überprüfung der Isolierung, die geeignet sind, die Isolierung zwischen zwei Leitern mindestens eines Leiterpaars, genannt getestetes Leiterpaar, von den Phasenleitern zu überprüfen, wobei die Mittel zur Überprüfung der Isolierung mindestens ein Modul (50) zum Einspeisen eines elektrischen Hochfrequenzsignals, das eine Spannung kleiner als eine Schwellenspannung und eine zweite Frequenz größer als die erste Frequenz aufweist, und eine Multiplexschaltung (56) aufweisen, die die Einspeisung des elektrischen Hochfrequenzsignals in jedes Paar von zu testenden Leitern gestattet.

2. Sicherheitsvorrichtung nach Anspruch 1, **dadurch gekennzeichnet, dass** die Mittel (34, 36) zur Überprüfung der Isolierung geeignet sind, jedes Paar von Phasenleitern zu überprüfen.

3. Sicherheitsvorrichtung nach Anspruch 1 oder 2, **dadurch gekennzeichnet, dass** die Mittel (34, 36) zur Überprüfung der Isolierung geeignet sind, außerdem die Isolierung jedes Leiterpaars, das von jeweils einem der Phasenleiter und dem Nullleiter gebildet wird, und jedes Leiterpaars, das von jeweils einem der Phasenleiter und dem Schutzleiter gebildet wird, zu überprüfen.

4. Sicherheitsvorrichtung nach einem beliebigen der Ansprüche 1 bis 3, **dadurch gekennzeichnet, dass** die Mittel (34, 36) zur Überprüfung der Isolierung außerdem einen Hochpassfilter (60) aufweisen, der am Ausgang der Multiplexschaltung angeschlossen ist und eine Grenzfrequenz größer als die erste Frequenz des Dreiphasenstroms und kleiner als die zweite Frequenz des elektrischen Hochfrequenzsignals aufweist.

5. Sicherheitsvorrichtung nach einem beliebigen der Ansprüche 1 bis 4, **dadurch gekennzeichnet, dass** die Multiplexschaltung (56) des eingespeisten Hochfrequenzsignals eine Anordnung von Schaltelementen (80, 82, 84, 86, 88) aufweist, die ausgebildet sind, eine Verbindung zwischen den Leitern der Leitung (8) des elektrischen Dreiphasennetzes und dem eingespeisten elektrischen Hochfrequenzsignal herzustellen.

6. Sicherheitsvorrichtung nach Anspruch 5, **dadurch gekennzeichnet, dass** die Multiplexschaltung fünf Schaltelemente aufweist, die jeweils einen auf einen Ausgang von zwei Ausgängen schaltbaren Eingang aufweisen, die so geschaltet sind, dass jeder der elektrischen Leiter (PH1, PH2, PH3, N, PE) der stromführenden Leitung (8) des Netzes an mindestens einen Ausgang eines Schaltelements (80, 82, 84, 86, 88) geschaltet ist.

7. Sicherheitsvorrichtung nach Anspruch 6, **dadurch gekennzeichnet, dass** jeder Phasenleiter (PH1, PH2, PH3) an den Ausgang von zwei unterschiedlichen Schaltelementen (80, 82, 84, 86, 88) geschaltet ist.

8. Sicherheitsvorrichtung nach einem beliebigen der Ansprüche 4 bis 7, **dadurch gekennzeichnet, dass** sie ein Modul (62) zur Messanpassung und einen Spannungs-Messkreis (64) aufweist, der an den Ausgang des Moduls (62) zur Messanpassung geschaltet ist und geeignet ist, eine Spannungsmessung, die das Vorhandensein einer Restspannung anzeigt, und eine Impedanzmessung, die das Nichtvorhandensein eines Fehlers einer elektrischen Isolierung für jedes getestete Leiterpaar angibt, durchzuführen.

9. Sicherheitsvorrichtung nach einem beliebigen der vorhergehenden Ansprüche, **dadurch gekennzeichnet, dass** sie eine Überprüfungssteuervorrichtung (24, 46) aufweist, die geeignet ist, die Mittel (32) zur Überprüfung des Vorhandenseins einer Restspannung und die Mittel (34, 36) zur Überprüfung der Isolierung zu steuern.

10. Sicherheitsvorrichtung nach Anspruch 9, **dadurch gekennzeichnet, dass** sie eine Mensch-Maschine-Schnittstelle (26, 48) aufweist, die geeignet ist, Befehle einer Bedienperson zu empfangen und Ausgaben hinsichtlich der überprüften Sicherheitsbedingungen zu liefern.

11. Sicherheitsvorrichtung nach Anspruch 10, **dadurch gekennzeichnet, dass** die Mensch-Maschine-Schnittestelle Leuchtanzeigen (30a, 30b, 30c) aufweist, die geeignet sind, Hinweise hinsichtlich der überprüften Sicherheitsbedingungen zu liefern.

12. Verfahren zur Sicherheitsüberprüfung, das von einer Sicherheitsvorrichtung nach Anspruch 1 durchgeführt, **dadurch gekennzeichnet, dass** es umfasst:
- Überprüfen (150) einer ersten Sicherheitsbedingung des Vorhandenseins einer Spannung größer als eine vorbestimmte Sicherheitsschwelle auf einem der Phasenleiter, und
- im Falle des Nichtvorhandenseins einer Spannung größer als die Sicherheitsschwelle, Überprüfen (150) der Isolierung, das geeignet ist, die Isolierung zwischen zwei Leitern mindestens eines Leiterpaars, genannt getestetes Leiterpaar, von den Phasenleitern zu überprüfen,
- Anzeigen (160, 170, 180) des Ergebnisses jedes Überprüfungsschritts mittels einer Mensch-Maschine-Schnittstelle der Sicherheitsvorrichtung.

13. Verfahren zur Sicherheitsüberprüfung nach Anspruch 12, **dadurch gekennzeichnet, dass** es außerdem nach dem Überprüfen der ersten Sicherheitsbedingung das Überprüfen (110) einer zweiten Sicherheitsbedingung eines Verbindungsausfalls mit einem der Phasenleiter aufweist.

14. Verfahren zur Sicherheitsüberprüfung nach einem beliebigen der Ansprüche 12 oder 13, **dadurch gekennzeichnet, dass** bei dem Schritt des Überprüfens (150) der Isolierung alle Phasenleiterpaare, alle Paare, die jeweils von einem der Phasenleiter und dem Nullleiter gebildet werden, und alle Paare, die jeweils von einem der Phasenleiter und dem Schutzleiter gebildet werden, überprüft werden.

15. Verfahren zur Sicherheitsüberprüfung nach Anspruch 14, **dadurch gekennzeichnet, dass** eine Gefahrenanzeige von der Mensch-Maschine-Schnittstelle der Sicherheitsvorrichtung ausgeführt wird sobald der Schritt der Überprüfung der Isolierung ein Fehlen der Isolierung anzeigt.

16. Verfahren zur Sicherheitsüberprüfung nach Anspruch 13 und einem der Ansprüche 14 bis 15, **dadurch gekennzeichnet, dass** die erste und zweite Sicherheitsbedingung vor und nach dem Durchführen des Schrittes des Überprüfens der Isolierung überprüft werden.

## Claims

1. A safety device (16, 16a, 16b, 16c, 16d, 16e, 40) adapted to be connected between a circuit breaker device (14, 14a, 14b, 14c, 14d, 14e) and an electric installation powered by an electric grid providing three-phase current having a first associated frequency, using a line (8) for conveying electric current comprising three phase conductors (PH1, PH2, PH3), a neutral conductor (N) and a protection conductor (PE), the device making it possible to verify at least one electric safety condition following a cut off of electric power of the electric installation by the circuit breaker device (14, 14a, 14b, 14c, 14d, 14e), **characterized in that** it comprises means (32) for verifying the presence of a residual voltage above a predetermined safety threshold on at least one of the conductors and isolation verification means (34, 36), capable of verifying the isolation between two conductors of at least one pair of conductors, called tested pair of conductors, from among said phase conductors, said isolation verification means including a module (50) for injecting a high-frequency electric signal, having a voltage below a voltage threshold, and a second frequency above said first frequency, and a multiplexing circuit (56) adapted to inject said high frequency electric signal toward each pair of conductors to be tested.

2. The safety device according to claim 1, **characterized in that** the isolation verification means (34, 36) are adapted to verify each pair of phase conductors.

3. The safety device according to one of claims 1 or 2, **characterized in that** the isolation verification means (34, 36) are further adapted to verify the isolation of each pair of conductors formed by each of said phase conductor and the neutral conductor, and each pair of conductors formed by each of said phase conductors and the protection conductor.

4. The safety device according to any one of claims 1 to 3, **characterized in that** the isolation verification means (34, 36) further comprise, connected at the output of the multiplexing circuit (56), and connected to said phase conductors, an injection filter (60) of the high-pass type, with a cutoff frequency above said first frequency of the three-phase current and below said second frequency of the high-frequency electric signal.

5. The safety device according to any one of claims 1 to 4, **characterized in that** the multiplexing circuit (56) of the injected high-frequency electric signal comprises a set of switching members (80, 82, 84, 86, 88) arranged to produce coupling between said conductors of the line (8) for conveying electric current of the three-phase electric grid and the injected high-frequency electric signal.

6. The safety device according to claim 5, **characterized in that** the multiplexing circuit (56) comprises five switching members (80, 82, 84, 86, 88) each having an input switchable on one output from among two outputs, connected such that each of the electric conductors (PH1, PH2, PH3, N, PE) of the line (8) for conveying electric current of the grid is connected on at least one output of a switching member (80, 82, 84, 86, 88).

7. The safety device according to claim 6, **characterized in that** each phase conductor (PH1, PH2, PH3) is connected as output of two separate switching members (80, 82, 84, 86, 88).

8. The safety device according to any one of claims 4 to 7, **characterized in that** it comprises a measurement adaptation module (62) and a voltage measurement circuit (64) connected on the output of the measurement adaptation module (62) and capable of performing a voltage measurement indicating the presence of a residual voltage and an impedance measurement indicating the absence of an electric isolation fault for each tested pair of conductors.

9. The safety device according to any one of the preceding claims, **characterized in that** it comprises a command control member (24, 46) capable of checking said means (32) for verifying the presence of a residual voltage and said isolation verification means (34, 36).

10. The safety device according to claim 9, **characterized in that** it comprises a man-machine interface (26, 48) capable of receiving commands from an operator and providing indications relative to the verified safety conditions.

11. The safety device according to claim 10, **characterized in that** the man-machine interface comprises luminous indicators (30a, 30b, 30c) capable of providing indications relative to the verified safety conditions.

12. A method for verifying safety implemented by a safety device according to claim 1, **characterized in that** it comprises:
- verifying (150) a first safety condition for the presence of a voltage above a predetermined safety threshold on one of the phase conductors,
- and, if there is no voltage above the security threshold, an isolation verification (150), capable of verifying the isolation between two conductors of at least one pair of conductors, called tested pair of conductors, among said phase conductors,
- using (160, 170, 180) at least one man-machine interface of the safety device to display the result upon each verification step.

13. The safety verification method according to claim 12, **characterized in that** after verifying the first safety condition, it further comprises verifying (110) a second safety condition relative to the loss of connection with one of the phase conductors.

14. The safety verification method according to any one of claims 12 or 13, **characterized in that** in the isolation verification step (150), all of the pairs of phase conductors, all of the pairs respectively formed by one of the phase conductors and the neutral conductor, and all of the pairs respectively formed by one of the phase conductors and the protection conductor are verified.

15. The safety verification method according to claim 14, **characterized in that** a risk indicator is implemented on the man-machine interface of the safety device once the isolation verification step indicates a lack of isolation for a pair of conductors.

16. The safety verification method according to claim 13 and one of claims 14 to 15, **characterized in that** said first and second safety conditions are verified before and after carrying out the isolation verification step.
